# EUROPEAN PATENT APPLICATION

(11) **EP 3 434 646 A1**
(43) Date of publication of application: **30.01.2019**
(21) Application number: 17305996.5
(22) Date of filing: 25.07.2017
(51) Int. Cl.: C01B 33/037, C30B 13/06, C30B 13/24, C30B 29/06, C30B 35/00

(54) **METHOD FOR RECYCLING SUB-MICRON SI-PARTICLES FROM A SI WAFER PRODUCTION PROCESS**

(71) Applicant: Total Solar International, 92400 Courbevoie (FR); SunPower Corporation, San Jose, CA 95134 (US)
(72) Inventor: SACHS, Christoph, 78530 Buc (FR)
(74) Representative: Croonenbroek, Thomas Jakob

(57) **Abstract**

The invention relates to a method for recycling sub-micron Si-particles from a Si wafer production process resulting from a diamond fixed abrasive process, in particular slicing and cutting comprising the steps of:
- providing a paste (3) of sub-micron Si-particles resulting from said diamond fixed abrasive process,
- drying and shaping into a layer (7) said paste of sub-micron Si-particles,
- applying a zone melting step to said dried and shaped layer of Si-particles on a substrate (5).

## Description

### FIELD OF THE INVENTION

The invention relates to a method for recycling sub-micron Si-particles from a Si wafer production process in particular for recycling Si-kerf from diamond wire sawing, more specifically in a way that it can be used to produce in particular silicon single-crystals of solar cell manufacturing quality.

### BACKGROUND AND PRIOR ART

Semiconductor industries rely on manufacturing of high quality silicon wafers at optimized cost.

During manufacturing, a silicon single crystal is manufactured from polycrystalline silicon by known methods like floating zone melting method (or FZ method in short) or Czochralski method (CZ method in short) or mono-like directional solidification methods.

The silicon single crystal has the form of an ingot or a block, mostly with a general cylindrical shape.

In order to obtain wafers, the single crystal ingot is sliced into thin wafers having a thickness in the range of 200 µm by a wire sawing / slicing process.

However, such a slicing process produces significant silicon waste which is known as silicon kerf waste.

At present the kerf loss corresponds to about a thickness of 200µm, meaning a loss of about 40% per unit length.

Bearing in mind that the semiconductor industry, in particular the part dedicated to photovoltaic tends to reduce the wafer thickness even more, the kerf losses might become even higher.

As the raw material for ingot manufacturing is already quite expensive, the important kerf losses, which are discarded, become a quite important economic problem.

First attempts have proposed to recycle the kerf waste. But recycling is difficult as kerf waste does not only contain silicon, but also, depending on the saw used and the sawing process, metallic particles, carbon and organic compounds from the liquid containing kerf (coolant or slurry). Such impurities, if not properly eliminated can lead to Si wafers of poor quality or even unusable wafers in particular for photovoltaic applications.

WO2012/109459 relates to a method for recovering silicon value from kerf silicon waste and discusses also other methods to recover kerf waste.

The present invention proposes a method to recycle more efficiently kerf losses when the kerf results from diamond fixed abrasion process like for example diamond wire sawing of silicon single crystal ingots.

To this extent, the present invention proposes a method for recycling submicron Si-particles from a Si wafer production process resulting from a diamond fixed abrasive process, in particular slicing and cutting comprising the steps of:
- providing a paste of sub-micron Si-particles resulting from said diamond fixed abrasive process,
- drying and shaping into a layer said paste of sub-micron Si-particles,
- applying a zone melting step to said dried and shaped layer of Si-particles on a substrate.

Thanks to the method according to the invention submicron Si-particles, in particular of less than 500nm in mean diameter can be recycled more efficiently and can contribute to cost reduction in Si wafer production. In particular the recycled kerf has the form of chips of solar grade silicon that can be used directly as feedstock in CZ pulling process.

The method according to the invention may comprise one or several of the following features taken alone or in combination:
According to one aspect, the step of providing a paste of sub-micron Si particles results from a diamond sawed slicing process.

The step of providing a paste of sub-micron Si particles resulting from a diamond sawed slicing process further may comprise:
- recovering of Si-kerf slurry form a diamond sawed slicing process,
- centrifugation of the Si-kerf slurry and drying in order to obtain said paste of submicron Si particles.

The step of centrifugation is for example carried out with a solid bowl decanter centrifuge.

The remaining moisture of the paste of sub-micron Si particles is for example below 50%, in particular between 35% - 45%, and more specifically 40%.

The drying step may be carried out under an inert atmosphere, in particular argon or nitrogen.

According to a further aspect, the drying step is carried out under at a temperature comprised between 350°C and 450°C, in particular between 390°C and 410°C, like for example 400°C.

The drying step may be preceded by a de-oxidation treatment, in particular with hydrofluoric acid.

The paste of sub-micron Si particles is for example compacted prior to said zone melting step.

The compacting step comprises in particular pressing or extrusion of said paste of submicron Si particles to obtain thin plates.

The zone melting step may be carried out under an inert atmosphere, in particular argon.

According to a further aspect, the zone melting step is configured to leave a sub-layer of unmolten Si-particles.

The melting depth during the zone melting step is configured to be for example superior to 1mm, in particular comprised between 10-20mm.

The submicron Si-particles resulting from a diamond fixed abrasive process have in particular a mean diameter inferior to 500nm, in particular a mean diameter comprised between 200nm-400nm.

After the zone melting step, the molten sub-micron Si- particles are for example cooled from one side for solidification in form of a sheet.

After the zone melting step, the solidified silicon sheet may be recovered and broken down in silicon chips.

The silicon chips can be edged chemically or mechanically to remove impurities.

The invention also relates to the use of silicon chips produced as described above as a feedstock for a Cz-pulling process for silicon single crystal manufacturing, for the production of multi-crystalline or mono-like silicon ingots.

### BRIEF DESCRIPTIONS OF THE DRAWINGS

Other advantages and characteristics will appear with the reading of the description of the following drawings:
- Figure 1 is a simplified flowchart of the method according to the invention,
- Figure 2 is a simplified view in cross section to illustrate one step of the method according to the invention,
- Figure 3 is a simplified view in cross section to illustrate another step of the method according to the invention,
- Figure 4 is a simplified view in perspective to illustrate the zone melting step,
- Figure 5 is a simplified view in cross section to illustrate the zone melting step according to a first embodiment,
- Figure 6 is a simplified view in cross section to illustrate the zone melting step according to a second embodiment, and
- Figure 7 shows an example of silicon chips produced through the method according to the invention.

### DETAILED DESCRIPTION

The embodiment(s) in the following description are only to be considered as examples. Although the description refers to one or several embodiments, this does not mean inevitably that every reference concerns the same embodiment, or that the characteristics apply only to a single embodiment. Simple characteristics of various embodiments can be also combined to new embodiments that are not explicitly described.

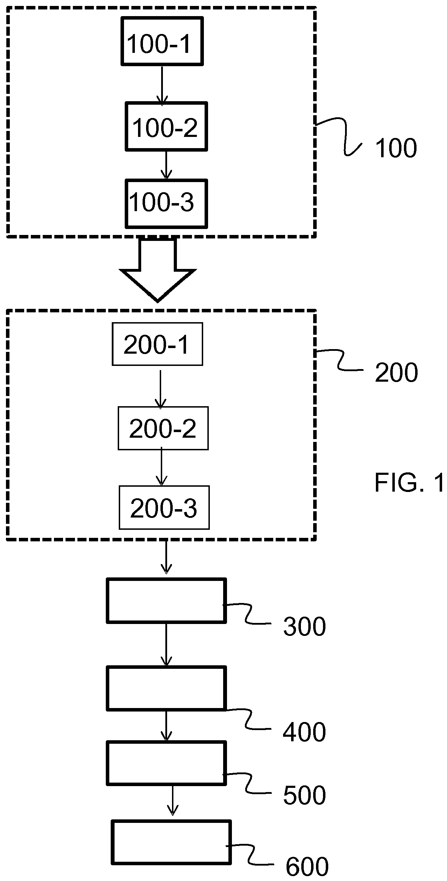

Figure 1 shows a simplified flowchart of the method for recycling submicron Si- particles from a Si wafer production process resulting from a diamond fixed abrasive cutting process.

The steps in the flowchart of figure 1 may be composed of sub-steps. In addition, same steps or sub-steps are optional and may be combined in another chronological order.

The method according to the invention applies to sub-micron Si- particles from a Si wafer production process resulting from a diamond fixed abrasive cutting process.

By sub-micron Si-particles, it is understood Si-particles having a mean diameter of less than µm, in particular with a mean diameter inferior to 500nm, and more precisely comprised between 200nm-400nm.

These very small particles are quite difficult to recycle because of their small size.

The fact that the Si-particles result from a Si wafer production process resulting from a diamond fixed abrasive cutting process means for example that they result from a diamond wire sawing process which is carried out in order to obtain wafers from a silicon single-crystal or multi-crystalline material.

These particles may be contained in the slurry (cutting fluid) of the sawing process, such slurry is also known as Si-kerf slurry.

The particularity of Si-kerf slurry resulting from a diamond fixed abrasive cutting process is that the solid content is mainly constituted by sub-micron Si-particles as described above.

The main contaminates of the Si-kerf slurry are:
- (I) metallic impurities such as nickel originating from the cutting wire itself,
- (II) cutting additives from the water based cutting fluid ,
- (III) diamonds broken off the wire during sawing.
- (IV) material from the beam or holder to which the ingot / squared silicon block is attached during the slicing operation

The silicon particles of the Si-kerf slurry are also oxidized on their surface because a thin silicon oxide layer is formed on the particle surfaces due to the presence of water and oxygen.

According to the invention, the sub-micron Si-particles are recycled in a way that they can be used directly as silicon feedstock in a CZ pulling process of Si single crystal ingots or alternatively for production of multi-crystalline / mono-like silicon ingots. The recycled silicon feedstock may be mixed with other silicon feedstock such as polysilicon from the Siemens process.

In the present example, sub-micron Si-particles from diamond sawing are used, but also other processes in the Si wafer production process like polishing may give raise to sub-micron Si-particles that may be recycled.

By "diamond fixed abrasive process", it is understood that the diamonds are fixed to the process tool, like for example the cutting wire. In other words, not included are abrasive processes using a bulk material like a powder with diamonds.

After diamond wire sawing, the silicon particles are dispersed in the cutting fluid that is usually water based and contains about 2 volume percent of additives. The typical solid loading is between 2 - 5 weight percent. The Si-particles are of submicron size as described above. No SiC particles are present in the slurry from diamond sawing.

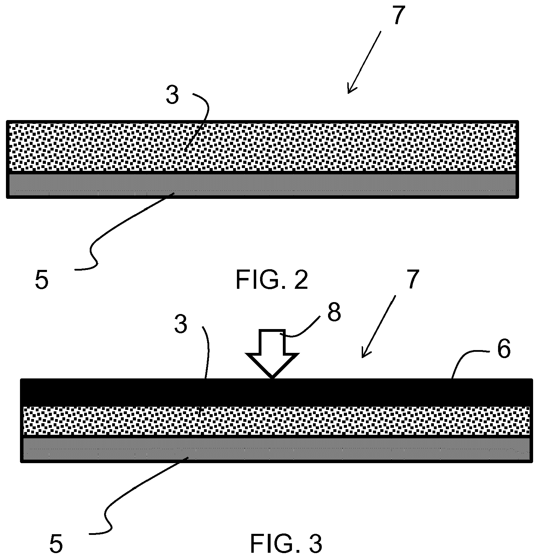

According to a first step 100, a paste 3 of sub-micron Si particles (see figure 2) resulting from said diamond fixed abrasive process is provided.

Step 100 of providing a paste 3 of sub-micron Si particles resulting from a diamond sawed slicing process may be carried out through a first sub-step 100-1 comprising the fact to recover of Si-kerf slurry form a diamond sawed slicing process and a second sub-step 100-2 comprising the centrifugation of the Si-kerf slurry and a third sub-step 100-3 comprising the fact of drying the centrifuged Si-kerf slurry in order to obtain said paste 3 of sub-micron Si particles.

The sub-step 100-2 of centrifugation is for example carried out with a solid bowl decanter centrifuge (not shown) also known as screw decanter. Such centrifuges are known to allow efficient separation of liquid and solids.

A solid bowl decanter centrifuge has a continuous unit comprising a bowl with a cylindrical section for efficient separation and clarification of the suspension and a conical section for efficient dewatering of the separated solids, a conveyor (screw) and a gear unit that provides the differential speed between the bowl and the conveyor. An example of such a solid bowl decanter centrifuge is described in EP0199929 and commercialized by Flottweg (registered trademark).

After drying sub-step 100-3, the remaining moisture of the paste 3 of sub-micron Si particles is below 50%, in particular between 35% - 45%, and more specifically 40%.

Once this paste 3 of sub-micron Si particles is obtained, it may be applied on a substrate 5 which has the function of a mechanical support. This is shown on figure 2 in a simplified way.

The substrate 5 should be realized in a material that will not interact with the Si-particle or silicon. In addition, it should maintain its shape even if it's subject to important temperature gradients. The substrate 5 may be rigid or flexible. In the latter case, it may be realized as a conveyor belt for example. The substrate 5 may be made of graphite, silicon carbide, silica or alumina for example. A coating to prevent interaction of the silicon with the substrate 5 may be foreseen.

Then in step 200, the paste 3 of sub-micron Si-particles is dried and shaped into a layer 7 like shown in a simplified way on figure 2.

In sub-step 200-1, the paste 3 is shaped, meaning for example applied to the substrate 5 to form a layer 7 of a certain thickness of at least 10mm, but preferentially between 20-25mm.

Optionally, a de-oxidation treatment, in particular with hydrofluoric acid may be carried out in a sub-step 200-2.

Then in sub-step 200-3, the layer 7 is further dried for example in an oven under an inert atmosphere, in particular argon or nitrogen, and at a temperature comprised between 350°C and 450°C, in particular between 390°C and 410°C, like for example 400°C.

Optionally, in a step 300, the dried and shaped layer 7 is then compacted, as can be seen in figure 3, in particular by pressing a plate 6 (see arrow 8) or extrusion of said paste 3 of submicron Si particles to obtain for example thin plates.

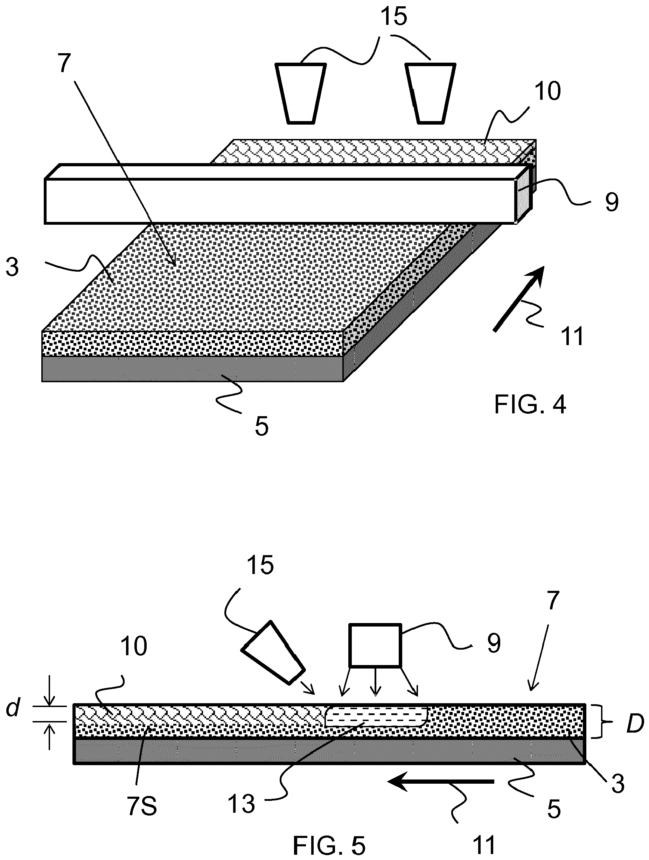

As shown in figures 4, 5 and 6, a zone melting step 400 is applied to said dried and shaped layer 7 of Si particles on said substrate 5. This zone melting step 400 is carried out under an inert atmosphere, in particular argon.
In zone melting the dried and shaped layer 7, Si particles are molten in a narrow region and give raise to solidification of the silicon particles to form a solidified sheet of silicon 10.

Zone melting has the advantage to have a high surface to volume ratio allowing therefore for effective heat transfer and melting.

To this extent, for example a strip heater element 9 disposed in front of the substrate 5 carrying the dried and shaped layer 7 of Si particles and the substrate 5 is for example moved according arrow 11 with respect to the strip heater element 9. The moving speed of the substrate 5 with respect to the strip heater element can range from 10-1000mm/min.

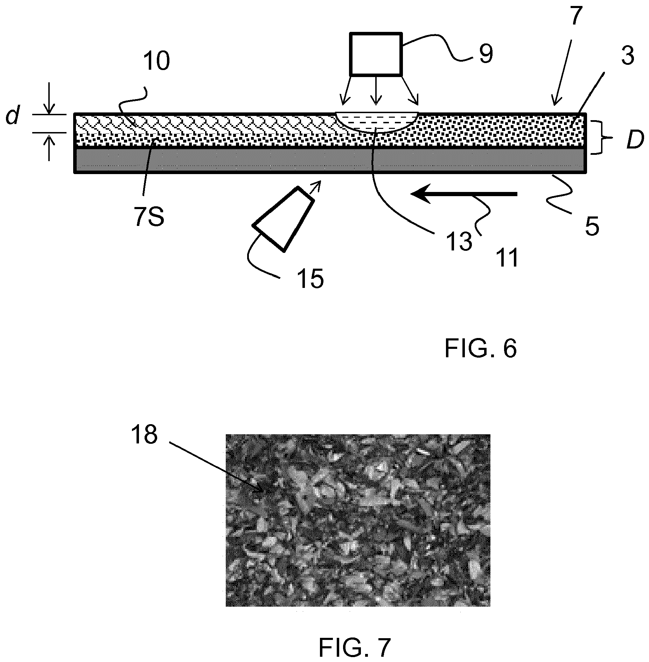

The strip heater element 9 may comprise a halogen emitter with an optical concentrator directing the generated heat towards the dried and shaped layer 7 of Si-particles. The strip heater may also be a SiC or graphite filament / rod / narrow serpentine heater
As seen on the figures 5 and 6, beneath the strip heater element 9 is established a well localized melting zone 13.

In function of several parameters, in particular the shape of the emitted heat radiation, the moving speed of the substrate 7 with respect to the strip heater element 9 and, as will be explained later on, well positioned cooling devices (like gas jets 15, or heat sinks - the molten silicon in the melting zone 13 may be cooled from one side, top side or bottom side), the form, extent end depth d of the melting zone 13 can be controlled.

The creation of a well-defined temperature profile allows to control closely melting and especially solidification.

The melting depth d during the zone melting step is configured to be above 1mm, in particular about 10-20mm, but less than the overall thickness D of the layer 7.

Indeed, the zone melting step 400 is configured to leave a sub-layer 7S of unmolten Si-particles, for example with a thickness *(D-d)* superior to 0.1mm, in particular 1-2mm. This facilitates the separation of the solidified silicon from the substrate 5, once the solidified silicon has cooled down.

The temperature profile governs the heat flow and consequently the shape of the liquid solid interface, the direction of the solidification of the molten silicon, and nucleation that defines the microstructure and grain size.

In figure 5, cooling gas jets 15 are positioned on the top face. In this case, heat is mainly extracted from the top and solidification can start on the top of the melt surface and progresses towards the non-molten part of layer 7 in direction to the substrate 5. Instead of a cooling gas another heat sink or heat extraction device may be used.

In this case, impurities will be transported by segregation to the bottom of the silicon sheet 10 that is formed through solidification after the melting zone 13. After cooling down, the solidified Si - sheet 10 is enriched with impurities at its boundaries which can be removed chemically, e.g. by etching, or mechanically.

The remaining silicon sheet 10 has lower impurity content than the original paste 3 of submicron Si-particles and can be further processed, e.g. broken into chips or granules.

In figure 6, cooling gas jets 15 are positioned on the bottom face. In this case, heat is extracted mainly from the bottom and solidification can start on the bottom of the melt at the interface to the non-molten silicon particles. This will result in columnar grain growth because nucleation will be caused by the non-molten powder layer. Silicon melt that solidifies last can be trapped between individual grains and be expelled to the silicon surface as small beads or droplets. This silicon material has a high concentration of impurities and can be subsequently removed mechanically, e.g. sieving, or by other methods.

The control of the temperature profile also allows controlling of the temperature gradient at the solid liquid interface. A sharp temperature gradient can prevent dendritic growth during crystallization of the molten silicon by avoiding an undercooled silicon melt. This is beneficial for the segregation of impurities during the solidification.

Another aspect of controlling the temperature profile is the ability to tailor the microstructure and grain size of the solidified silicon. If the silicon material is broken afterwards the grain size directly correlates with the obtained particle size. The regions between the grains can be enriched with impurities. These impurities can be removed by washing of the particles and simultaneously etching, e.g. with nitric / hydrofluoric acid as commonly done in industry. Thus, controlling the microstructure during solidification allows governing the impurity distribution in the solidified silicon.

In zone melting, the silicon submicron particles forming a sheet can be cooled down rapidly below a temperature at which back diffusion of impurities does not occur anymore. It is noteworthy that this cannot be achieved in crucibles based segregation methods that are commonly used in industry.

As oxygen can evaporate during the melting as well, the zone melting step 400 does not only consolidate the Si-particles but also represents a first cleaning step.

After the zone melting step, the solidified silicon is recovered and broken down in chips 18 in a step 500 (see also figure 7).

As stated above, these silicon chips 18 may be edged chemically or mechanically in a step 600 in order to remove impurities that accumulated at the surface of the chips.

These silicon chips 18 are now of high added value and are considered as solar grade silicon as they can be used directly as feedstock in particular for a CZ-pulling process or production of multi-crystalline or mono-like silicon ingots.
Indeed, the benefit of the obtained silicon sheet, chips or beads is that it has a high fill factor and can be more effectively molten in a crucible.

Depending on the individual composition of paste of sub-micron Si-particles resulting from said diamond fixed abrasive process, a further refining or segregation step may be necessary in order to remove metallic impurities. This further refining or segregation step may take place after one of the steps 400, 500 or in particular 600 as described above.
Dopants such as boron or phosphorous are present in sufficient low concentration in the recovered silicon after the zone melting step 400.
Several possibilities for refining or segregation are available, like the following that are mentioned as non-limiting examples:
1) The silicon sheet, chips or beads obtained by zone melting step 400 may be re-molten in performing the zone melting step 400 twice, directly after the first zone melting step 400, but preferably after having edged chemically or mechanically in step 600 the chips 18 in order to remove impurities that accumulated at the surface of the chips.
2) The silicon sheet, chips or beads obtained by zone melting step 400 may be re-molten in an electro-magnetic casting process (EMC) to produce a round or square ingot. From this ingot solar grade silicon can be obtained.
3) The silicon sheet, chips or beads obtained by zone melting step 400 may be re-molten in a directional solidification process (DS) to produce square silicon ingots.
4) The silicon sheet, chips or beads obtained by zone melting step 400 step may be processed by melt refining. In this process the silicon is dissolved in molten aluminum and precipitated by lowering the temperature and solubility of silicon in molten aluminum. Such a process is disclosed in patent US8562932 B2.
5) After zone melting step 400, the silicon material may be converted into metallurgical grade silicon (MG Si) feedstock by simple crushing or milling the silicon sheet. This material could be reintroduced into the FBR hydrochlorination of the standard Siemens process.

Thus, the method as disclosed above allows quite efficiently recycling of sub-micron Si-particles from a Si wafer production process resulting from a diamond fixed abrasive process, in particular slicing and cutting and to get rid of the difficulties to melt a powder of sub-micron silicon particles due to its low thermal conductivity and the presence of silicon oxide on the particle surface.

## Claims

1. Method for recycling sub-micron Si-particles from a Si wafer production process resulting from a diamond fixed abrasive process, in particular slicing and cutting comprising the steps of:
- providing a paste (3) of sub-micron Si-particles resulting from said diamond fixed abrasive process,
- drying and shaping into a layer (7) said paste of sub-micron Si-particles,
- applying a zone melting step to said dried and shaped layer of Si-particles on a substrate (5).

2. Method as to claim 1, wherein the step of providing a paste of sub-micron Si particles results from a diamond sawed slicing process.

3. Method as to claim 2, wherein the step of providing a paste of sub-micron Si particles resulting from a diamond sawed slicing process further comprises:
- recovering of Si-kerf slurry form a diamond sawed slicing process,
- centrifugation of the Si-kerf slurry and drying in order to obtain said paste of submicron Si particles.

4. Method as to claim 3, wherein the step of centrifugation is carried out with a solid bowl decanter centrifuge.

5. Method as to any of claims 1 to 4, wherein the remaining moisture of the paste of sub-micron Si particles is below 50%, in particular between 35% - 45%, and more specifically 40%.

6. Method as to any of claims 1 to 5, wherein the drying step is carried out under an inert atmosphere, in particular argon or nitrogen.

7. Method as to any of claims 1 to 6, wherein the drying step is carried out under at a temperature comprised between 350°C and 450°C, in particular between 390°C and 410°C, like for example 400°C.

8. Method as to any of claims 1 to 7, wherein the drying step is preceded by a de-oxidation treatment, in particular with hydrofluoric acid.

9. Method as any of claims 1 to 8, wherein the paste of sub-micron Si particles is compacted prior to said zone melting step.

10. Method as to claims 9, wherein the compacting step comprises pressing or extrusion of said paste of submicron Si particles to obtain thin plates.

11. Method as to any of claims 1 to 10, wherein the zone melting step is carried out under an inert atmosphere, in particular argon.

12. Method as to any of claims 1 to 11, wherein the zone melting step is configured to leave a sub-layer of unmolten Si-particles.

13. Method as to any of claims 1 to 12, wherein the melting depth during the zone melting step is configured to be superior to 1mm, in particular comprised between 10-20mm.

14. Method as to any of claims 1 to 13, wherein the submicron Si-particles resulting from a diamond fixed abrasive process have a mean diameter inferior to 500nm, in particular a mean diameter comprised between 200nm-400nm.

15. Method as to any of claims 1 to 14, wherein after the zone melting step, the molten sub-micron Si- particles are cooled from one side for solidification in form of a sheet.

16. Method as to any of claims 1 to 15, wherein after the zone melting step, the solidified silicon sheet is recovered and broken down in silicon chips (18).

17. Method as to claim 16, wherein the silicon chips (18) are edged chemically or mechanically to remove impurities.

18. Use of silicon chips (18) produced according to any of claims 1 to 17 as a feedstock for a Cz-pulling process for silicon single crystal manufacturing or for the production of multi-crystalline or mono-like silicon ingots.
